Europäisches Patentamt

European Patent Office

Office européen des brevets

(11) Publication number: **0 373 501 B1**

# EUROPEAN PATENT SPECIFICATION

(45) Date of publication of patent specification: **08.03.95**    (51) Int. Cl.6: **C09G 1/02**, H01L 21/306

(21) Application number: **89122550.0**

(22) Date of filing: **07.12.89**

(54) **Fine polishing composition for wafers.**

(30) Priority: **12.12.88 JP 313480/88**

(43) Date of publication of application:
**20.06.90 Bulletin 90/25**

(45) Publication of the grant of the patent:
**08.03.95 Bulletin 95/10**

(84) Designated Contracting States:
**BE DE FR GB IT**

(56) References cited:
**EP-A- 0 322 721**
**FR-A- 2 414 387**
**US-A- 4 581 042**

**PATENT ABSTRACTS OF JAPAN, vol. 10, no.
85 (C-336)[2142], 4th April 1986;& JP-A 60 219
274 (DAINIPPON INK KAGAKU KOGYO K.K.)
01-11-1985**

(73) Proprietor: **E.I. DU PONT DE NEMOURS AND
COMPANY
1007 Market Street
Wilmington
Delaware 19898 (US)**

(72) Inventor: **Sasaki, Shigeo Kanayama Jutaka-
6-54
Chayama 3-chome
Jonan-ku
Fukuoka-shi
Fukuoka-ken (JP)**

(74) Representative: **Woodcraft, David Charles et
al
BROOKES & MARTIN
High Holborn House
52/54 High Holborn
London, WC1V 6SE (GB)**

**Description**

This invention relates to a composition for smoothly polishing the surface of a wafer widely used as a substrate crystal for electrical integrated circuits, more specifically, to a fine polishing composition for smoothly polishing the surface of a wafer to remove irregularities greater than 10 m$\mu$.

Wafers which are widely used as substrates for electrical integrated circuits are typically produced by slicing a silicon or germanium crystal ingot, and the surface of these wafers is polished to form a flat surface having as less irregularities as possible, which are then used for the formation of circuits.

This is because, if there are irregularities on the surface of the wafer when circuits patterns are depicted on the surface of the wafer, precise and fine depicting will become difficult, and uneven electrical characteristics of the wafer will result.

Heretofore, to polish the surface of such a wafer, there have been proposed a variety of polishing agents.

For example, the specification of U.S. Patent 3,170,273 discloses a silica sol containing 2 to 50% by weight of silica and a silica gel containing 2 to 100% of silica as polishing agents. The specification of U.S. Patent 3,328,141 discloses that when these polishing agents are mixed with an alkaline compound to adjust the pH value to 10.5 to 12.5, the resulting polishing agent have increased polishing speeds. However, observation by a differential interference microscope or the like of the surface of wafers polished using these polishing agents has revealed irregularities of 5 to 500 m$\mu$, showing that these polishing agents are not very satisfactory.

Japanese Patent Publication No.53-9910/1978 discloses a polishing agent containing quartz, silicates, and hexafluorosilicates, and further containing a monohydric alcohol having 3 to 5 carbon atoms, arid polyvinyl alcohol. However, with such a polishing agent, a fully satisfactory surface has not yet been obtained, and a polishing agent containing these alcohols has a problem in that it is difficult to store the polishing agent for a long period of time.

Furthermore, Japanese Patent Publication No.61-14655/1986 (corresponding to the specification of U.S. Patent 4,260,396) discloses a polishing agent containing water-soluble carboxymethylene rubber or xanthane gum. However, this polishing agent has problems in that it requires a long polishing time required to obtain a smooth polished surface and subsequently a long time for so-called after-polishing with water for cleaning. Moreover, it involves an increased minimal amount of silica required for the formation of a smooth surface, which is another disadvantage of this polishing agent.

EP-A-0 322 721 discloses a fine polishing composition for wafers comprising water, particulate amorphous silica and a polysaccharide polymer graft-polymerized with acrylamide alone or together with at least one vinyl monomer selected from the group consisting of acrylic acid, methacrylic acid and styrenesulfonic acid, and adjusted with an alkaline substance to a pH of from 8 to 12.

This document is cited pursuant to Article 54(3) and (4) EPC.

JP-A-60 219 274 discloses an aqueous composition containing 10 - 100 pts.wt. (on a solid basis) aqueous copolymer dispersion (A) obtained by emulsion-polymerizing a mixture consisting of 1.0 - 20.0 pts.wt., $\alpha,\beta$-monoethylenically unsaturated carboxylic acid monomer, 0.1 - 10.0 pts.wt. monomer containing a polymerizable unsaturated double bond and an alkoxysilane group and 1.0 - 200.0 pts.wt. (on a solid base) colloidal silica, 0 - 50 pts.wt. alkali-soluble resin (B) in a quantity of 50 wt% or below based on that of component A, 0 - 100 pts.wt. wax (C) , 0.5 - 20 wt% (based on the combined quantity of components A, B and C) wetting agent, dispersant and/or emulsifier (D), 55 - 75 wt% (based on the quantity of component A) plasticizer and/or filmforming aid (E) and 0 - 50 wt% (based on the quantity of component A) polyvalent metal complex (F).

With a view to eliminate the prior art problems of polishing compounds, it is a primary object of the present invention to provide:

1. a polishing agent which gives a polished surface having no irregularities detectable by a differential interference microscope,

2. a polishing agent which requires a short polishing time to obtain a smooth surface,

3. a polishing agent which requires a less amount of silica to obtain a smooth surface, and

4. a polishing agent which can be stably stored for a long period of time.

The inventors have conducted intensive studies to solve the above problems. As s result, the inventors have obtained findings that the above object is attained by a compound which is based on a slurry containing colloidal silica particles, with a specific water-soluble polymeric compound and a specific water-soluble salt, and have accomplished the present invention.

In accordance with the present invention which attains the above object, there is provided a fine polishing composition for polishing a wafer comprising water, colloidal silica particles, a water-soluble polymeric compound, and a water-soluble salt, said colloidal silica particles having an average particle diameter of 5 m$\mu$ to 500 m$\mu$ and having silanol groups on the surface thereof in a surface density of 1 to 10 groups/nm$^2$, said water-soluble polymeric compound having a molecular weight of 100.000 or more and comprising one or more types selected from the group consisting of polyethylene oxide, polyacrylamide, polyvinylpyrrolidone, polyacrylic acid, polymethacrylic acid, polyitaconic acid, polymaleic acid, a copolymer of acrylamide and acrylic acid and schizophyllan, said water-soluble salt comprising one or more combinations of a cation selected from the group consisting of lithium, sodium, potassium and ammonium and an anion selected from the group consisting of fluoride, chloride, bromide, iodide, sulfate, nitrate, perchlorate, carbonate, formate, acetate, acrylate, and oxalate, the pH value of said final polishing compound being adjusted to 8 to 12.

The present invention will now be described in detail. The colloidal silica useful for the present invention is referred to a stable colloidal dispersion of amorphous silica in a liquid. In this liquid, average particle diameter of the silica particles ranges from 5 to 500 m$\mu$, more preferably 100 m$\mu$ or less. If the average particles size is less than 5 m$\mu$, ratios of silicic acid monomer and oligomer contained in the colloidal dispersion will become increased and, when the surface of a wafer is polished using such a polishing compound, silica tends to adhere to the surface of the wafer, which is undesirable. If the average particle diameter exceeds 500 m$\mu$, the surface of the wafer tends to be scratched, which is also undesirable.

The average particle diameter used in the present invention, when the particles are present separately with no agglomerations, means average particle diameter of the particles under that condition or, when the particles are agglomerated, means average particle diameter of the particles under that condition.

The colloidal silica useful for the present invention has silanol on the surface of the particles in a surface density of 1 to 10 groups/nm$^2$. When silanol on the surface of the particles has a surface density within the above range, hydrophilicity of the silica particles is improved, and the polishing compound has improved dispersibility in water compared with a polishing agent containing a silica powder which has silanol in a surface density of less than 1 group/nm$^2$.

Surface density of silanol on the surface of the silica particles can be determined, for example, by the following method:

(1) First, silica sol is ion-exchanged to remove metal ions. Sodium hydroxide is added dropwise to the ion-exchanged silica sol (W g) to determine molar number (M) of sodium hydroxide required for the pH value to reach 8. Reaction in this case is considered to progress as follows:

$$Si\text{-}OH + NaOH \rightarrow Si\text{-}ONa + H_2O$$

(2) Silica content (S weight %) of the ion-exchanged silica sol is determined by a drying method.
(3) Surface density of silanol is calculated by the following equation:

$$\text{Surface density (group/nm}^2\text{)} = \frac{\text{Number of silanol in silica sol}}{\text{Surface area of silica in silica sol}}$$

Number of silanol in silica sol = M x 6 x 10$^{23}$ (unit: group)

Surface area of silica in silica sol

$$= \frac{W \times S}{100 \times 2.2 \times 10^{-21}} \times \frac{4\pi r^2}{\frac{4\pi}{3} \cdot r^3}$$

$$= \frac{3}{220} W \times S \times \frac{10^{21}}{r} \qquad (\text{unit: nm}^2)$$

$$\text{Surface density (group/nm}^2) = \frac{M \times 6 \times 10^{23}}{\frac{3}{220} W \times \frac{1}{r} \times 10^{21}}$$

$$= \frac{440 \times M \times r}{W \times S} \times 100$$

wherein, r denotes an average particle radius (nm) of silica particles.

Colloidal silica having silanol in a surface density of 1 to 10 groups/nm$^2$ is obtained by subjecting water glass, with reduced content of sodium ions thereof, and silicic acid to a condensation polymerization reaction to form silica particles. Details of a production method for such colloidal particles are described in Chapter 3 of "The chemistry of silica: Solubility, polymerization, colloid and surface properties, and biochemistry" Ralph K. Iler JOHN WILEY & SONS(1979).

The polishing composition according to the present invention contains a water-soluble polymeric compound. The polymeric compound, on polishing a wafer, serves to form a regular laminar flow between a polishing cloth and the surface of the wafer in the sliding direction of the polishing cloth to make the wafer surface even further smooth.

The water-soluble polymeric compound includes polymers of acrylamide, acrylic acid, methacrylic acid, maleic acid, itaconic acid, ethylene oxide, and vinylpyrrolidone, or copolymers of these monomers, schizophyllan. Particularly preferable water-soluble polymeric compounds are polyacrylamide, a copolymer of acrylic acid and acrylamide, and schizophyllan.

These compounds have molecular weights of 100,000 or more. If the molecular weight is less than 100,000, a laminar flow is not formed between the polishing cloth and the surface of wafer during polishing, which is undesirable. Molecular weight of the polymeric compound used in the present invention is referred to that measured by a light scattering method (e.g., refer to Shin Jikken Kagaku Koza (New Experimental Chemistry), vol.19, p.571-585, published by Maruzen in 1978).

The water-soluble polymeric compound is prepared using the following procedures.

Polyacrylamide, a copolymer of acrylamide and acrylic acid, polyacrylic acid, polymethacrylic acid, polyitaconic acid, polymaleic acid, polyethylene oxide, and polyvinylpyrrolidone can be prepared by polymerization of the corresponding monomers using a conventional method known in the art.

Content of the water-soluble polymeric compound in the inventive polishing composition is typically 1 ppm or more and, specifically, preferably 10 to 1,000 ppm. When a wafer is polishing using a polishing composition having a content of the water-soluble polymeric compound within this range, a laminar flow is formed in the sliding direction between the polishing cloth and the wafer surface, thereby making the wafer surface even smoother. However, if the content is less than 1 ppm, it is difficult to form the laminar, and, if the content exceeds 1,000 ppm, a turbulent flow tends to be formed; both cases are undesirable.

The inventive polishing composition contains a water-soluble salt. The water-soluble salt has a function to reduce the thickness of hydration layer on the surface of silica particles in the slurry-formed fine polishing compound. This increases the kinetic action of the silica particles exerting on the wafer during polishing with the polishing compound, thereby increasing the mechanical polishing effect and improving the polishing efficiency.

4

The water-soluble salt comprises neutral salts comprising combinations of a cation selected from the group consisting of lithium, sodium, and potassium, and an anion selected from the group consisting of fluoride, chloride, bromide, iodide, sulfate, nitrate, and perchlorate. These water-soluble salts can be used alone or in combination of two or more types. Of these, potassium chloride, potassium perchlorate and ammonium chloride are particularly preferable which are high in degree of ion dissociation and large in atomic radius of cation.

Content of the water-soluble salt in the inventive fine polishing composition for a wafer is typically 20 ppm or more. The thickness of hydration layer formed on the surface of silica particles can be reduced by the addition of the water-soluble salt, however, if the content is less than 20 ppm, a sufficient effect of the salt is not obtained, which is undesirable.

The inventive fine polishing composition for a wafer is mixed with an alkaline compound to adjust the pH value of the compound to 8 to 12.

As the alkaline compound, hydroxide of an alkali metal, an amine, or ammonia can be used. The alkali metal hydroxide includes potassium hydroxide, sodium hydroxide, rubidium hydroxide, and cesium hydroxide. Of these, potassium hydroxide and sodium hydroxide are particularly preferable. The amine includes triethylamine, triethanolamine, monoethanolamine, diisopropanolamine, ethylenediamine, tetraethylpentamine, triethylpentamine, diethylenetriamine, and hexamethylenediamine. Of these, ethylenediamine is preferable.

The present invention has the following advantageous effects and is thus very important for use in industrial applications.

(1) When a wafer is polished using the inventive fine polishing composition, the water-soluble polymeric compound forms a laminar flow between the polishing cloth and the wafer, thereby preventing occurrence of a turbulent flow. Therefore, a smooth polished surface is obtained which has no irregularities detectable by a differential interference microscope.

(2) Since the inventive fine polishing composition contains colloidal silica as silica particles having on the surface silanol groups in a surface density of 1 to 10 groups/nm$^2$, it has a high hydrophilicity of silica particles and an improved dispersibility in water, compared with a polishing agent which contains a silica powder containing silica particles having on the surface silanol groups in a density of 1 group/nm$^2$ or less.

(3) When a wafer is polished using the inventive fine polishing composition, because the thickness of hydration layer on the surface of colloidal silica particles in the slurry is small due to the function of the water-soluble salt contained in the composition, kinetic action of the silica particles exerted on the wafer when the silica particles impinge upon the wafer during polishing is increased, thereby increasing the mechanical polishing effect, and thus the fine polishing efficiency is improved over that for polishing with a composition which does not contain the salt.

The present invention will now be described further in detail with reference to examples and comparative examples, but these examples are not intended to limit the invention. Examples 1-15, Comparative Examples 1-2

(1) Preparation of polishing composition

Colloidal silica having an average particle diameter of 60 millimicrons, containing 50 weight % of silica particles, and having silanol on the surface of the particles in a surface density of 8 groups/nm$^2$; an aqueous solution (0.5 weight %) of polyacrylamide (from Mitsubishi Kasei, named Diaclear MN3000) (hereinafter referred to as "PAAM"), schizophyllan (hereinafter referred to as "SPH"); and KCl as the water-soluble salt were weighed in ratios shown in Table 1, and mixed with pure water to obtain polishing compounds containing 0.1 weight % colloidal silica. However, for Comparative Example 2, silica powder (from Nippon Silica Kogyo, named Nipseal E220A, having silanol in a surface density of 1 group/nm$^2$ on the particle surface) was dispersed in pure water in an amount of 1 weight %.

(2) Fine polishing tests of wafer

Using the SPAW36 Polisher of Speed Fam and a soft, suede-type polishing cloth, a silicon wafer was polished while supplying the polishing compound at a rate of 1 liter per minute. Polishing pressure was 100 g/cm$^2$, relative speed between the wafer and the polishing cloth was 1 m/sec, and temperature of the polishing cloth during polishing was 40°.

Time was determined until the surface of the wafer became smooth by polishing using the polisher (whether or not the surface was smooth was observed by a differential interference microscope in the course of polishing). The results are shown in Table 1.

After polishing by the polisher, the wafer was polished with a rinse and water in place of the polishing compound to remove silica and water-soluble polymers from the surface of the wafer. Time required for rinse polishing was determined (end point was determined by observation of the wafer surface with the differential interference microscope).

(3) Silica particle dispersion tests of polishing compounds

A slurry-formed fine polishing composition was put in a capped test tube of 5 cm in height and 100 cc in volume, which was allowed to stand for one day. The test tube was subjected to repeated cycles of turning upside down and then reverting back to the original position, and condition of silica particles uniformly dispersing in the slurry was observed visually to determine the number of cycles required for uniform dispersion.

Table 1

| Item | Water-soluble polymeric compound | | Water-soluble salt | | Alkaline substance | | Wafer polishing test | | Silica dispersion test of polishing composition |
|---|---|---|---|---|---|---|---|---|---|
| No. | Type | Content (ppm) | Type | Content (%) | Type | pH value of compound | Time for smooth surface | Rinse polishing time | |
| **Example** | | | | | | | | | |
| 1 | PAAM | 100 | KCl | 0.005 | – | 9.8 | 15 | 30 | 5 |
| 2 | PAAM | 100 | KCl | 0.005 | Ethylenediamine | 11.0 | 13 | 30 | 5 |
| 3 | PAAM | 100 | KCl | 0.01 | – | 9.7 | 10 | 30 | 5 |
| 4 | PAAM | 100 | KCl | 0.05 | – | 9.6 | 5 | 30 | 5 |
| 5 | PAAM | 100 | KCl | 0.1 | – | 9.6 | 3 | 30 | 5 |
| 6 | SPH | 100 | KCl | 0.005 | – | 9.8 | 10 | 30 | 5 |
| 7 | SPH | 100 | KCl | 0.005 | Ethylenediamine | 11.0 | 9 | 30 | 5 |
| 8 | SPH | 100 | KCl | 0.01 | – | 9.7 | 5 | 30 | 5 |
| 9 | SPH | 100 | KCl | 0.05 | – | 9.6 | 3 | 30 | 5 |
| 10 | SPH | 100 | KCl | 0.1 | – | 9.6 | 1 | 30 | 5 |
| **Comparative Example** | | | | | | | | | |
| 1 | – | – | – | – | – | 9.8 | over 20 min | | 5 |
| 2 | PAAM | 100 | – | – | Ammonia | 10.0 | 5 | 1 min | 100 |

The following can be seen from Table 1:

1. When a wafer is polished using the inventive polishing composition, in particular, using that containing large amounts of the water-soluble salt, fine polishing time is reduced and the polishing composition is suited for use as a polishing agent. Furthermore, silica particles of the slurry have good dispersibility, which makes the polishing composition easy to handle.

2. On the other hand, a polishing composition such as Comparative Example 1 which does not contain a water-soluble polymeric compound cannot achieve fine polishing. When silica particles are given in the form of a silica powder as in Comparative Example 2, the polishing compound is suitable for fine polishing, but is inferior in dispersibility to the inventive polishing compound and requires continuous stirring during polishing operation.

**Claims**

1. A fine polishing composition for polishing a wafer comprising water, colloidal silica particles, a water-soluble polymeric compound, and a water-soluble salt, said colloidal silica particles having an average particle diameter of 5 m$\mu$ to 500 m$\mu$ and having silanol groups on the surface thereof in a surface density of 1 to 10 groups/nm$^2$, said water-soluble polymeric compound having a molecular weight of 100.000 or more and comprising one or more types selected from the group consisting of polyethylene oxide, polyacrylamide, polyvinylpyrrolidone, polyacrylic acid, polymethacrylic acid, polyitaconic acid, polymaleic acid, a copolymer of acrylamide and acrylic acid and schizophyllan, said water-soluble salt comprising one or more combinations of a cation selected from the group consisting of lithium, sodium, potassium and ammonium and an anion selected from the group consisting of fluoride, chloride, bromide, iodide, sulfate, nitrate, perchlorate, carbonate, formate, acetate, acrylate, and oxalate, the pH value of said final polishing composition being adjusted to 8 to 12.

2. The fine polishing composition for polishing a wafer as claimed in claim 1 wherein said water-soluble salt is selected from the group consisting of potassium chloride, potassium perchlorate and ammonium chloride.

3. The fine polishing composition for polishing a wafer as claimed in claim 1 containing said colloidal silica in an amount of 0.1 weight %, said water-soluble polymeric compound in an amount of 1 ppm or more, and said water-soluble salt in an amount of 20 ppm or more.

**Patentansprüche**

1. Feinpoliturmasse zum Polieren eines Wafers, umfassend Wasser, kolloidale Kieselsäureteilchen, eine wasserlösliche polymere Verbindung, ein wasserlösliches Salz, wobei die genannten Teilchen der kolloidalen Kieselsäure einen durchschnittlichen Teilchendurchmesser von 5 $\mu$m bis 500 $\mu$m besitzen und Silanolgruppen auf ihrer Oberfläche in einer Oberflächendichte von 1 bis 10 Gruppen/nm$^2$ aufweisen und die genannte wasserlösliche Polymerverbindung ein Molekulargewicht von 100 000 oder mehr aufweist und ein oder mehrere Typen, ausgewählt aus der Gruppe, bestehend aus Polyethylenoxid, Polyacrylamid, Polyvinylpyrrolidon, Polyacrylsäure, Polymethacrylsäure, Polyitaconsäure, Polymaleinsäure, einem Copolymer von Acrylamid und Acrylsäure und Schizophyllan, umfaßt, wobei das genannte wasserlösliche Salz eine oder mehrere Kombinationen aus einem Kation, ausgewählt aus der Gruppe, bestehend aus Lithium, Natrium, Kalium und Ammonium, und ein Anion, ausgewählt aus der Gruppe, bestehend aus Fluorid, Chlorid, Bromid, Iodid, Sulfat, Nitrat, Perchlorat, Carbonat, Formiat, Acetat, Acrylat und Oxalat, umfaßt und wobei der pH-Wert der genannten fertigen Politurmasse auf 8 bis 12 eingestellt ist.

2. Feinpoliturmasse zum Polieren eines Wafers nach Anspruch 1, worin das genannte wasserlösliche Salz ausgewählt wird aus der Gruppe, bestehend aus Kaliumchlorid, Kaliumperchlorat und Ammoniumchlorid.

3. Feinpoliturmasse zum Polieren eines Wafers nach Anspruch 1, enthaltend die genannte kolloidale Kieselsäure in einer Menge von 0,1 Gew.-%, wobei die genannte wasserlösliche polymere Verbindung in einer Menge von 1 ppm oder mehr und das genannte wasserlösliche Salz in einer Menge von 20 ppm oder mehr vorhanden sind.

**Revendications**

1. Composition de polissage fin pour polir une rondelle, comprenant de l'eau, des particules de silice colloïdale, un composé polymère hydrosoluble et un sel hydrosoluble, lesdites particules de silice colloïdale ayant un diamètre moyen des particules de 5 $\mu$m à 500 $\mu$m et ayant des groupes silanols sur la surface celles-ci, en une densité de surface de 1 à 10 groupes/nm$^2$, ledit composé polymère hydrosoluble ayant un poids moléculaire de 100 000 ou plus et comprenant un ou plusieurs types choisis dans le groupe constitué d'un oxyde de polyéthylène, d'un polyacrylamide, d'une polyvinylpyrrolidone, d'un acide polyacrylique, d'un acide polyméthacrylique, d'un acide polyitaconique, d'un acide polymaléique, d'un copolymère de l'acrylamide et de l'acide acrylique, et du schizophyllane, ledit sel hydrosoluble comprenant une ou plusieurs combinaisons d'un cation choisi dans le groupe constitué des cations lithium, sodium, potassium et ammonium, et d'un anion choisi dans le groupe constitué des anions fluorure, chlorure, bromure, iodure, sulfate, nitrate, perchlorate, carbonate, formiate, acétate, acrylate et oxalate, la valeur de pH de ladite composition de polissage finale étant ajustée à 8 à 12.

2. Composition de polissage fin pour polir une rondelle selon la revendication 1, dans laquelle ledit sel hydrosoluble est choisi dans le groupe constitué du chlorure de potassium, du perchlorate de potassium et du chlorure d'ammonium.

3. Composition de polissage fin pour polir une rondelle selon la revendication 1, contenant ladite silice colloïdale en une quantité de 0,1 % en poids, ledit composé polymère hydrosoluble en une quantité de 1 ppm ou plus et ledit sel hydrosoluble en une quantité de 20 ppm ou plus.